# EUROPEAN PATENT SPECIFICATION

(11) **EP 0 778 359 B1**
(45) Date of publication and mention of the grant of the patent: **22.08.2001**
(21) Application number: 96308845.5
(22) Date of filing: 05.12.1996
(51) Int. Cl.: C23C 16/44, H01L 21/00

(54) **Reduction of particulate contamination in wafer processing**
Reduzierung der Partikelverunreinigung in der Halbleiterfertigung
Réduction de contamination des particules dans le traitement de plaquettes

(30) Priority: 05.12.1995 US 567455
(43) Date of publication of application: 11.06.1997
(73) Proprietor: APPLIED MATERIALS, INC., Santa Clara, California 95054-3299 (US)
(72) Inventor: Mak, Alfred, Union City, CA 94587 (US); Chen, Ling, Sunnyval, CA 94086 (US); Chen, Yu Pei, Dallas, Texas 75243 (US); Sherstinsky, Semyon, San Francisco, CA 94121 (US); Englhardt, Eric, Palo Allto, CA 94301 (US); Wang, Vincent, Cupertino, CA 95014 (US); Salfelder, Joseph F., Williston, Vermont 05495 (US); Chafin, Michael G., San Jose California 95117 (US)
(74) Representative: Bayliss, Geoffrey Cyril

(56) References cited:
- EP-A- 0 254 651
- US-A- 4 883 020
- US-A- 4 976 996

## Description

This invention relates to improvements in the processing of semiconductor wafers. More particularly, it relates to a method and apparatus for reducing particulate contamination of semiconductor wafers during processing.

During the manufacture of microelectronic devices, it is necessary to deposit layers of various materials on a semiconductor wafer. This is typically done in a deposition chamber of a processing apparatus. Several methods of depositing layers of materials on the wafer exist, such as chemical vapor deposition (CVD), evaporation, epitaxy, and sputtering. Materials deposited typically include silicon, silicon dioxide, aluminium, tungsten, titanium nitride and others.

Etching is also used in producing the desired structures on the semiconductor wafer. This may be accomplished by chemical etching or dry etching. Chemical etching is accomplished by applying a reactive fluid, such as nitrogen trifluoride gas, to the surfaces to be etched. In dry etching, the surface of the wafer is bombarded by a plasma, which may contain fluorine or chlorine ions that react with the surface material, or may remove atoms by physically knocking them off the structure. An example of an etch chamber is disclosed in US-A-4,842,683.

As chip densities increase and semiconductor devices shrink, the quality of fabrication becomes more crucial. The composition, structure, and stability of deposited films must be carefully controlled and the reduction of particulate contamination in particular becomes increasingly crucial as device sizes shrink and device densities increase. As the devices grow smaller, they become more sensitive to particulate contamination, and a contaminant particle size that was once considered acceptable may now be a fatal defect. The presence of particles during deposition or etching of thin films may cause voids, dislocations, short circuits, or open circuits, all of which adversely affect the yield and performance reliability of microelectronic devices.

Significant reduction in particulate contamination has been achieved by improved techniques to clean wafer surfaces, cleaner clean rooms, and improvements to semiconductor processing equipment. However, many particles are generated inside the processing apparatuses themselves, by both mechanical wear and by the processes themselves.

Often, the process gases will react and deposit material on other surfaces in the reactor besides the substrate. The walls of the processing chambers may be coated with various materials deposited during processing, and mechanical and thermal stresses may cause these materials to flake and become dislodged, generating contaminant particles. In processing steps that use a plasma, many ions, electrons, radicals, and other chemical "fragments" are generated. These may combine to form particles that eventually deposit on the substrate or on the walls of the reactor.

Also, particulate contamination may be introduced by other sources, such as during wafer transfer operations and backstream contamination from the pumping system used to evacuate the processing chamber.

In plasma processing, contaminant particles typically become trapped in the chamber, between a plasma sheath adjacent to the wafer and a plasma glow region. These particles pose a significant risk of contamination, particularly at the end of plasma processing, when the power that sustains the plasma is switched off. In many plasma processing apparatuses, a focus ring is disposed above and at the circumference of the wafer to enhance uniformity of processing by controlling the flow of active plasma species to the wafer, such as during a plasma etch process. The focus ring, and an associated wafer clamping mechanism, tends to inhibit removal of the trapped particles by gas. It will be appreciated that there is thus a need to provide a reliable and inexpensive process to remove such particles from the wafer processing chamber.

Similarly, in chemical vapor deposition and etching, material tends to deposit on various parts of the apparatus, such as the susceptor, the showerhead, and the walls of the reactor, as the by-products of the processing condense and accumulate. Mechanical stresses may cause the deposited material to flake and become dislodged. These mechanical stresses are often caused by wafer transfer operations, but may also be caused by abrupt pressure changes induced by switching gas flow on and off and by turbulence in gas flow. Thus, process by-products at the end of the processing stage must be flushed from the chamber to prevent them from condensing and accumulating inside the chamber.

Typically, the flow of processing gas is shut off at the end of a processing stage, whereupon the pressure in the chamber rapidly falls to zero as the vacuum pump continues to run. Idle purge may be used, in which purge gas is introduced into the chamber at intervals while no processing is taking place. Nonetheless, pressure spikes occur with the cycling of gas flow, causing disruption of particles which may then contaminate the wafer surface. This limits the particle reduction benefits from the idle purge. A large portion of device defects are caused by particles disrupted by pressure change during wafer loading and moisture on the pre-processed wafer surface.

Furthermore, the flow of gas in the processing chamber is generally non-laminar. The presence of turbulent regions reduces the efficiency of the flow in flushing particulate contaminants from the reactor, as the particles tend to remain in the chamber rather than being carried out by the flow of gas.

In addition, the pump itself may increase the level of particulate contamination. The pump, which is used to evacuate the processing chamber, may produce particle backstream at low ambient pressures in the chamber. At low pressures, molecular flow conditions exist and the mean free path of molecules is large. The viscous forces and mass transport are insufficient to suppress particle movement in the chamber. This means that any particles backscattered by the pump will move into the reactor unimpeded by gas flow. Thus, the motion of the pump impeller could easily propel particles throughout the entire chamber.

EP-A-0254651 discloses chemical vapour deposition process and an apparatus for carrying out the process in which a reaction gas flow in a process chamber is externally controlled to concentrate reaction components only in the vicinity of a substrate, thereby growing a thin film of high quality on the substrate with good reproducibility, uniformity and controllability.

There remains a need for an improved method and apparatus for reducing the level of particulate contamination in semiconductor wafer processing operations, particularly when the wafer is not being processed.

This invention provides a method of processing a substrate in a substrate processing reactor defining a processing chamber, comprising the steps of inserting the substrate into the chamber; flowing a processing fluid into the chamber; and terminating the flow of processing fluid; wherein a laminar flow of a non-processing purge fluid is maintained after terminating the flow of processing fluid; and the substrate is removed from the chamber without interrupting the flow of purge fluid.

In terms of the invention, the reactor is continuously purged with an inert purge gas through a gas inlet when no wafer process is taking place. At the same time, a vacuum pump exhausts the purge gas. Parameters such as the type of purge gas, flow rate of the purge gas, chamber pumping characteristics, and base pressure in the reactor are selected so that the flow of purge gas is in the laminar flow regime.

This flow of purge gas sweeps up the particulate contaminants and carries them out of the reactor. The flow of purge gas is laminar.

A satisfactorily laminar flow may be produced by retrofitting existing apparatuses and using the correct pressure and flow rate. However, the reactor may be configured and dimensioned to aid in the production of a laminar, flow through the reactor. This may be accomplished, for example, by configuring the gas inlets, as well as by the shape and placement of the wafer processing kit. Sufficient pumping is also required to maintain stable flow.

An advantage of this invention is that particulate contamination is significantly reduced, thereby improving the quality of the semiconductor processes.

Another advantage of this invention is that due to the reduction in the level of particulate contamination, the time between preventive chamber cleanings may be extended. This reduces the downtime for the wafer processing apparatus, thereby increasing its productivity.

The invention also provides an apparatus for performing processing operations on a wafer, comprising a processing chamber configured to house the wafer; and a plurality of fluid supplies in communication with the chamber; wherein a controller is configured to provide a laminar flow of purge fluid from at least one of the fluid supplies to the chamber whenever the apparatus is not performing processing operations on the wafer.

An advantage of the apparatus is that existing apparatuses may easily be retrofitted to produce a sufficiently laminar flow through the reactor.

The following is a description of some specific embodiments of the invention reference being made to the accompanying drawings in which:
FIG. 1 is a schematic sectional view illustrating a conventional semiconductor processing apparatus for chemical dry etching of a wafer;
FIG. 2(a) is a graph illustrating the pressure change in the chamber at various times, for a prior art reactor;
FIG. 2(b) is a graph illustrating the pressure change in the chamber at various times, for a reactor incorporating the present invention;
FIG. 3(a) is a graph of the number of particles added by the process as a function of the number of wafers processed in the chamber, in a prior art chamber;
FIG. 3(b) is a graph of the number of particles added by the process as a function of the number of wafers processed in the chamber, in a chamber incorporating the present invention; and
FIG. 4 is a bar chart comparing the etch limited yields of the apparatus with and without the present invention.

The present invention provides for the reduction of particulate contamination in a semiconductor wafer processing chamber by providing a continuous laminar flow through the reactor whenever the reactor is not running a wafer process. By way of non-limiting example, this invention finds application in tungsten etchback (WEB) applications in an Applied Materials 5000 WEB apparatus. This apparatus can function both as a chemical etch or a plasma etch chamber. Details of an Applied Materials etch chamber may be found in US patent No. 4,842,683, entitled "*Magnetic Field-enhanced Plasma Etch Reactor*".

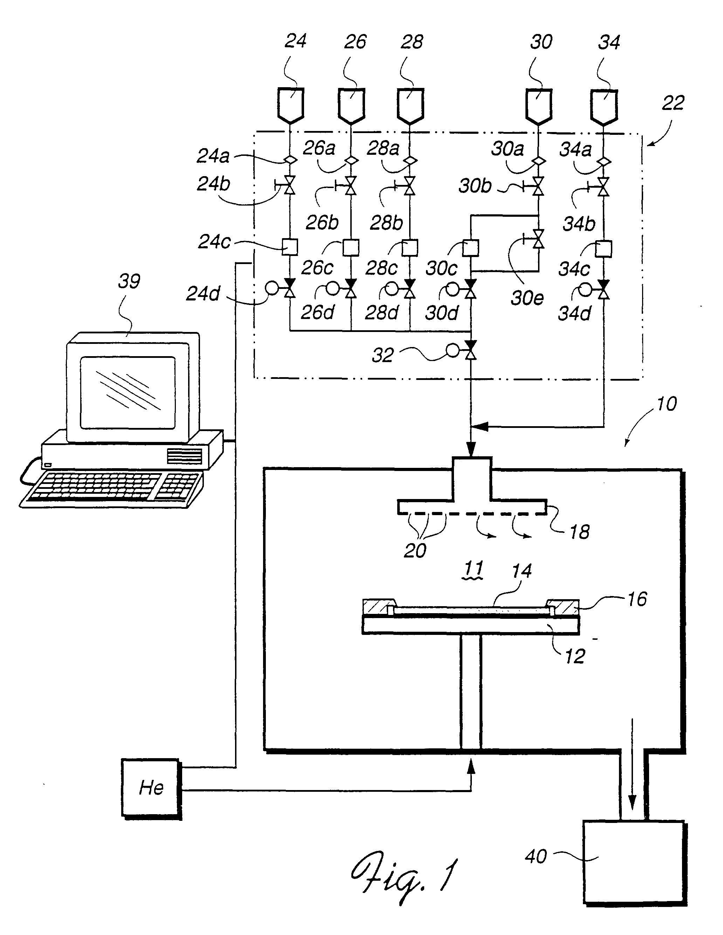

In FIG. 1, a schematic wafer processing reactor is generally indicated as 10 defines a processing chamber 11 which houses a substrate support, in the form of a pedestal 12, on which a wafer 14 is placed. The wafer may be secured to the pedestal during processing steps by either a clamp ring 16 or an electrostatic chuck (not shown).

A showerhead 18 having a plurality of holes 20 is placed above the wafer 14, and connected to a gas supply system (called a "gas panel" generally indicated as 22) located outside the reactor 10. The gas panel includes several gas supplies for gases used in the operation of the reactor 10. Argon is supplied from a remote source 24 through a filter 24a and a manually operated valve 24b to a mass flow controller 24c, which is set to permit 0-200 sccm of flow. The argon then passes through a pneumatic normally-closed (NC) valve 24d which is computer-controlled and permits flow in the direction of the chamber only. Nitrogen and sulfur hexafluoride are similarly supplied from separate sources 26, 28 through their own filters 26a, 28a, manually operated valves 26b, 28b, mass flow controllers 26c, 28c set at 0-300 sccm, and pneumatic NC valves 26d. 28d. Chlorine gas is also supplied from its source 30 through a filter 30a and manually operated valve 30b, and through a mass flow controller 30c set at 0-30 sccm. A second manually operated valve 30e permits efficient pumping of chlorine if needed during gas panel maintenance.

The above-described gases, after passing through their respective pneumatic NC valves, then pass through a single pneumatic NC valve 32, which is connected to the showerhead 18. These gases are used in wafer processing, and they will be referred to collectively as "the processing gas supply." The flow of gas from the processing gas supply may be shut off by the valve 32.

Furthermore, nitrogen purge gas flows from a source 34 through a filter 34a, manually operated valve 34b, a mass flow controller 34c which flows up to 500 sccm, and a pneumatic NC valve 34d, which is connected to the showerhead. The nitrogen purge gas does not flow through the pneumatic NC valve 32. This purge gas may also be argon, but nitrogen gas is preferred due to its lower cost. Also shown is an independent helium gas supply 38 which supplies cooling gas to the substrate support 12.

During normal reactor operation, the manually operated valves 24b, 26b, 28b, 30b are all turned on to permit gas flow through them. These valves can be manually shut off during maintenance operations, however. The gas panel 22 and Helium supply 38 are controlled by signals from a valve control mechanism (shown as a computer 39), which actuates the pneumatic NC valves to turn their respective gas flows on and off. In controlling the gas panel '22, the valve control mechanism 39 generates a control signal for the processing gas supply valve 32 which is the inverse of the control signal received by the purge gas supply valve 34d. Thus, at all times, one supply will be on while the other is off.

A pump 40 is connected to the bottom of the reactor chamber 11 to evacuate the chamber to a pressure of between 3.9 to 13.3 Pa (30 and 100 millitorr) during the purge step. The pump typically evacuates a 5000 WEB apparatus at a flow rate of about 200 sccm. The pump 40 must be chosen so that it can provide a steady flow of gases out of the chamber keeping the flow of gases in the chamber in the laminar regime.

In order to achieve this, a pump with a higher flow capacity than the actually pumping requirement should be chosen. Thus a pump capable of delivering a flow of 400 sccm or more should be used. One such pump is an Ebara 300 WS pump which is capable of pumping 600 sccm of gas. It is important to maintain a steady flow of gas out of the chamber as any surges could dislodge as backscatter particles into the chamber.

During wafer processing, the process gas supply valve 32 opens when it receives an ON signal from the computer 39. Because the inverse of that signal is OFF, the computer 39 asserts an OFF signal to the purge gas supply valve 34d, which turns the purge gas supply off. Thus, only processing gas flows through the showerhead, typically at a total flow rate of about 200 sccm. At the end of wafer processing, such as when wafer transfer is taking place or the reactor is idle, the processing gas supply valve supply 32 receives an OFF signal from the computer 39 and, in response, shuts off the flow of processing gas. At the same time, the computer 39 asserts an ON signal to the purge gas supply valve 34d, which opens to allow only purge gas to flow through the showerhead 18 and into the chamber 11.

The configuration of the showerhead 18, pressure in the reactor, flow rate of the purge gas, composition of the gas, and the pumping of the system are selected such that the flushing flow of purge gas is both stable and in the laminar flow regime. Maintaining laminar flow through the chamber is important for removal of contaminants. Laminar flow ensures that enough collisions exist between the molecules of purge gas to move contaminants with the stream of purge gas out the reactor. It has been found that a laminar flow rate resulting in estimated average 100 collisions per molecule passing through the chamber is satisfactory to operate this invention.

In contrast to laminar flow, molecular flow of the purge gas is unsatisfactory. In molecular flow the mean free path of the purge gas molecule is greater than the length of the path the molecule follows in passing through the chamber. Theoretically, this means that no molecular collisions take place and that no contaminants will be "swept" out of the chamber by the purge gas.

Similarly, turbulent flow creates swirling and unpredictable flow to the extent that contaminants are potentially dispersed through the chamber instead of being "swept" out.

To achieve the desired laminar flow with approximately 100 collisions per molecule requires the calculation of the mean free path of the molecule.

This calculation is based on standard formulae which are dependent on the pressure and temperature of the gas, in turn determined by the pressure and temperature within the chamber. This pressure and temperature can be adjusted so that the calculated mean free path is about one hundredth of the path the molecule takes as it moves through the chamber. This theoretically results in about 100 molecular collisions. For the Applied Materials 5000 WEB chamber, it has been found that nitrogen gas may be used at a flow rate of approximately 200 sccm to produce a laminar flow, at a base pressure of 3.9 to 13.3 Pa (30 to 100 millitorr) and ambient temperature of 45 degrees Celsius to achieve the required laminar flow.

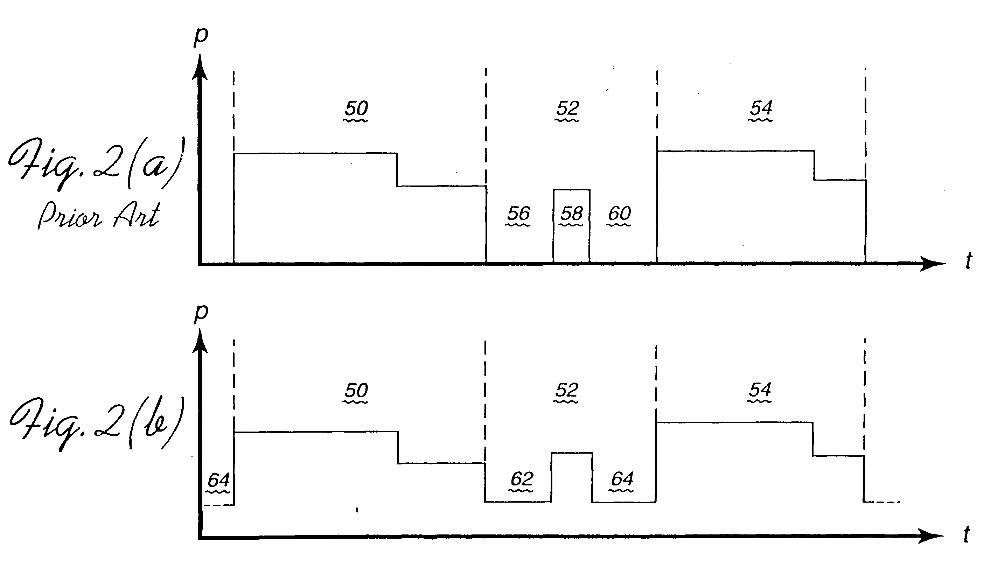

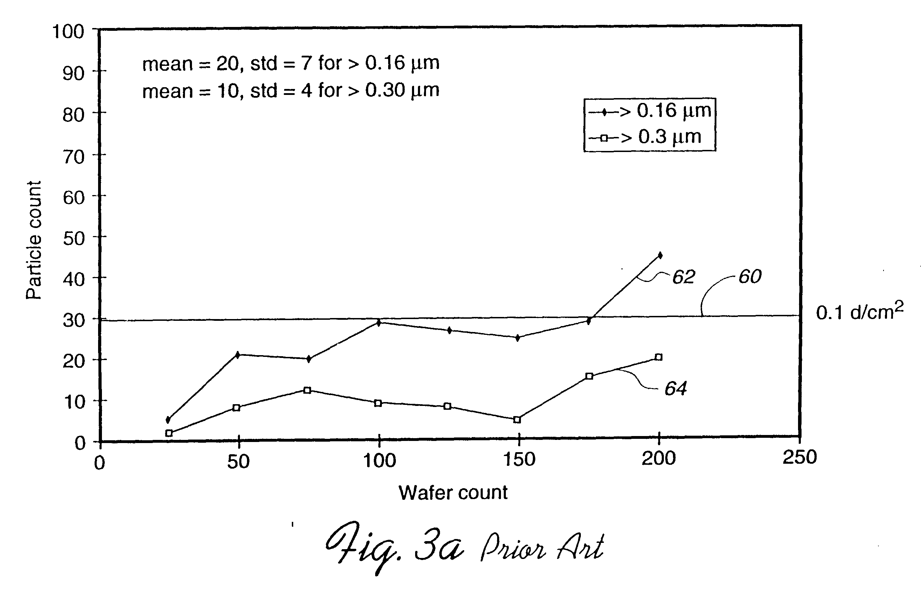

The transition time between the flow of processing gas and the flow of purge gas is very short, and the flow rates are substantially the same. Thus, the pressure changes are less severe than with a prior art system, which only purges the reactor during idle periods. This is graphically illustrated in FIGs. 2(a) and 2(b), which respectively show the ambient pressure in the reactor chamber 11 at various stages without and with the use of the present invention. Both these figures show a change in chamber pressure over time. Three distinct periods 50,52 and 54, respectively representing pressure during wafer processing, wafer transfer and wafer processing, are shown.

In a typical system without the use of the present invention as shown in FIG. 2 (a) the chamber is maintained at a certain pressure during processing 50. Thereafter, when the process gas flow is shut down, and no gas is supplied to the chamber 11, the pressure drops sharply as shown in sub-zone 56 as the pump 40 continues to evacuate the chamber 11. This drop in pressure may disrupt particles in the reactor and cause them to swirl around. Eventually, the pressure stabilizes at low pressure. When the wafer is transferred (by opening a loadlock to the chamber 11), the pressure rises sharply as shown in sub-zone 58, again stirring up the particles in the chamber 11. Thereafter, the loadlock closes and the pump continues to evacuate the chamber, prior to initiating processing, causing another sharp drop in pressure as shown by sub-zone 60. When processing begins, the introduction of processing gas causes yet another surge in pressure shown by zone 54. In a reactor incorporating the present invention, however, purge gas flows whenever the reactor is not running a process, particularly during two key periods: (1) between wafer loading and initiation of the process, shown by sub-zone 64; and (2) between the end of the process and the wafer transfer, shown by sub-zone 62. Because pre-process particles and contamination are the largest contributors to device defects, flushing before initiating the process significantly increases the quality of the process. Any disrupted particles due to the pressure change during wafer loading and contamination (i.e. moisture) present on the wafer surface might otherwise remain on the wafer surface, if the present invention were not used. Further, use of a laminar purge gas flow at the end of a wafer process allows floating byproducts to be flushed out by purge gas in order to prevent condensation in the reactor and settling on the surface of the wafer.

Because the flow should be viscous, the molecules of the flushing gas collide with the particles present in the reactor and sweep them up into the flow, which is then exhausted from the reactor by the pump. The laminar characteristic of the flow ensures that such particles are carried out of the reactor and do not remain in turbulent or stagnant areas in the chamber. Furthermore, because the net steady flow is upstream and out through the pump, particle backstream from the pump is suppressed.

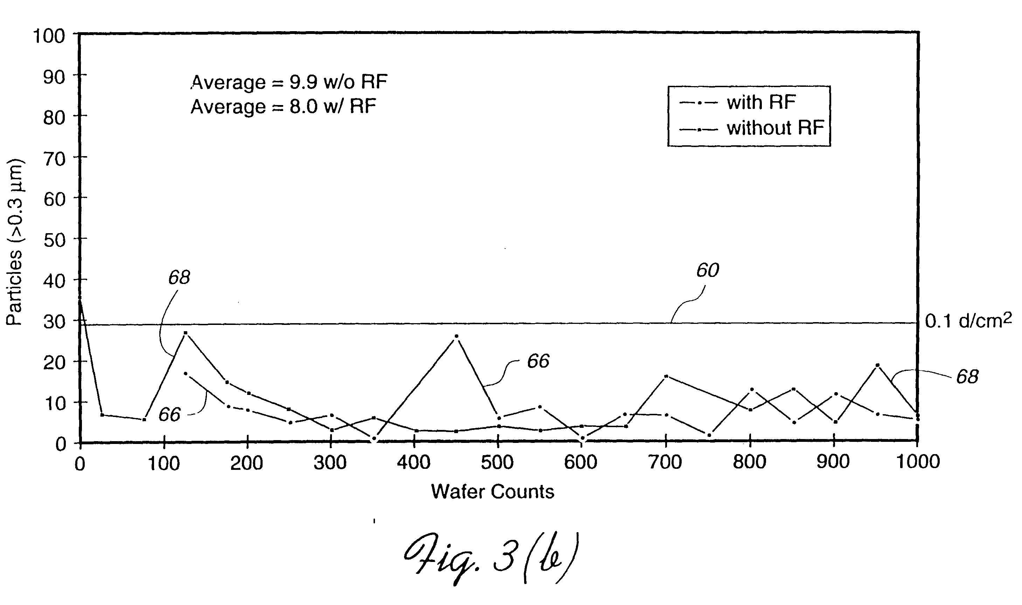

The effectiveness of the present invention in reducing particulate contamination may be seen by reference to FIG. 3(a) and 3(b), which show the particle counts for 200 mm wafer (commonly referred to as the 8 inch size) processed in a WEB without the invention and with it. Particle counts are taken by running a simulated process on a clean silicon wafer, and comparing the number of particles before and after the simulated process is run. In this way, the number of particles added by the process may be counted. Such added particles are commonly referred to as "adders." A standard testing machine, such as the Tencor 6200, may be used to count particles. For VLSI (Very Large Scale Integration) processes, the generally accepted quality standard is less than 0.1 defects per square centimeter, or 0.1 d/cm². This correlates to approximately 30 adders, and a line 60 is drawn on each of the graphs to represent this limit.

In FIG. 3(a) and 3(b), the number of new particles added by the process is graphed as a function of the number of wafers processed in the chamber since the last cleaning of the chamber. The two lines 62,64 plotted in FIG. 3(a) represent, respectively, the number of particles larger than 0.16 *µ*m (micron), and the number of particles larger than 0.3 *µ*m (microns). The general trend is upwards for both lines even though only 200 wafers were processed, illustrating the cumulative effect of particulate contamination. In a prior art reactor without the continuous laminar flow of purge gas provided by this invention, particles generated during processing remain in the reactor and are present during the processing of the next wafer, which in turn generates more particles. The number of particles thus increases as more wafers are processed.

In this figure, particle counts were taken at every 25 iterations of the simulated process. For particles larger than 0.16 *µ*m (microns), the mean count was 20 particles, with a standard deviation of 7 particles. For particles larger than 0.3 *µ*m (microns), the mean count was 10 particles, with a standard deviation of 4 particles. At a wafer count of 200, the limit of 30 adders (0.1 d/cm²) was exceeded for particles larger than 0,16 *µ*m. This would necessitate bringing the system off-line for maintenance and chamber cleaning, which reduces productivity. The graph is representative of many processes in the industry.

In FIG. 3(b), results are shown for the WEB incorporating the present invention, with rf (radio frequency) application in a plasma process, as shown by plot 66 and without rf application, in a chemical process as shown by plot 68. Nitrogen purge gas was used at a flow rate of 200 sccm, and particles larger than 0.3 *µ*m (microns) were counted. Particle counts were taken at every 25-50 iterations until the wafer count reached 200, and then at every 50 iterations thereafter. As can be seen from the graph, the general trend is fairly flat, and the particle count at 1000 iterations is actually lower than at 200 iterations. This demonstrates the effectiveness of the present invention in controlling the number of particles in the reactor and in negating the cumulative effect of particulate contamination.

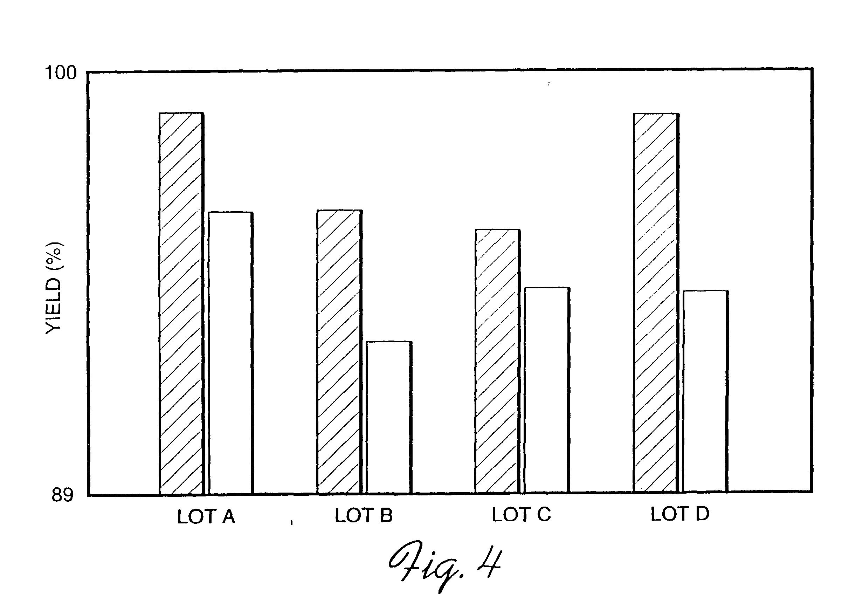

The reduction in particulate contamination achieved by the present invention is further illustrated in FIG. 4, which shows the etch limited yields (which are the process yields for only the etching step, not the overall device yields in the wafer fabrication) in a reactor with and without the present invention for test wafer lots A to D. As can be seen from the left hand column for each lot, the yield was higher with the present invention than without it. Although the increase in yield may only be on the order of a few percent, this can be a substantial increase in productivity.

Although the present invention has been described above in terms of a specific embodiment (that of an apparatus for use in a tungsten etchback process), it is anticipated that alterations and modifications thereof will no doubt become apparent to those skilled in the art. For example, the purge gas supplied to the chamber after processing has terminated can be supplied using any inert gas line already in the gas panel or by adding a separate gas line. Additionally, although the invention has been described for use in a chemical wafer processing chamber, the invention herein is equally suited for use in other substrate processing operations.

## Claims

1. A method of processing a substrate in a substrate processing reactor defining a processing chamber, comprising the steps of:
inserting the substrate into the chamber;
flowing a processing fluid into the chamber;
and terminating the flow of processing fluid;
characterised in that a laminar flow of a non- processing purge fluid is maintained after terminating the flow of processing fluid; and
the substrate is removed from the chamber without interrupting the flow of purge fluid.

2. A method as claimed in claim 1, characterised in that the step of maintaining the flow of purge fluid includes commencing the flow of purge fluid at the termination of the flow of processing gas.

3. A method as claimed in claim 2, characterised in that the purge fluid is a gas selected from the family consisting of the inert gases and nitrogen.

4. A method as claimed in claim 3, further comprising the step of constantly evacuating the purge gas from the chamber.

5. A method as claimed in claim 3, characterised in that the substrate is a semiconductor wafer.

6. A method of operating a substrate processing chamber in which a plurality of substrates are consecutively exposed to a flow of processing fluid, characterised in that the method comprises the step of maintaining a laminar flow of non-processing purge fluid through the chamber when a substrate is not being exposed to processing fluid.

7. A method as claimed in claim 6, further comprising the step of removing a substrate from the chamber, characterised in that the flow of purge fluid is maintained before, during and after the substrate is removed.

8. A method as claimed in claim 7, further comprising the step of inserting a substrate into the chamber, characterised in that the flow of purge fluid is maintained before, during and after the substrate is removed.

9. A method as claimed in claim 6, characterised in that the step of maintaining the laminar flow of purge fluid includes commencing the flow of purge fluid at the termination of the flow of processing gas.

10. A method as claimed in claim 9, characterised in that the purge fluid is a gas selected from the family consisting of the noble gases and nitrogen.

11. A method as claimed in claim 10, further comprising the step of constantly evacuating the purge gas from the chamber.

12. A method as claimed in claim 11, characterised in that the substrate is a semiconductor wafer.

13. An apparatus for performing processing operations on a wafer, comprising:
a processing chamber (11) configured to house the wafer (14);
and a plurality of fluid supplies (24 to 34) in communication with the chamber;
characterised in that a controller (34c) is configured to provide a laminar flow of purge fluid from at least one of the fluid supplies (34) to the chamber whenever the apparatus is not performing processing operations on the wafer.

14. An apparatus as claimed in claim 13, characterised in that the controller (34c) is configured to maintain the flow of purge fluid after terminating a flow of processing fluid from at least one of the fluid supplies.

15. An apparatus as claimed in claim 14, further comprising a wafer transfer mechanism configured to transfer the wafer into and out of the chamber; characterised in that the controller (34c) is configured to maintain the flow of purge fluid during wafer transfer.

16. An apparatus as claimed in claim 13, characterised in that the controller (34c) is configured to commence flow of purge fluid at the termination of flow of processing fluid.

17. An apparatus as claimed in claim 13, characterised in that the plurality of fluid supplies connected to the chamber include purge fluid gas supplies (24, 34) selected from the group consisting of inert gases and nitrogen.

18. An apparatus as claimed in claim 13, characterised in that the controller (34) is capable of providing a viscous flow of purge fluid.

19. An apparatus as claimed in claim 13, further comprising a pump (40) configured to constantly evacuate purge fluid from the chamber.

## Patentansprüche

1. Verfahren zum Behandeln eines Substrats in einem Substratbehandlungsreaktor, der eine Behandlungskammer bildet, wobei das Verfahren die Schritte aufweist
- Einführen des Substrats in die Kammer
- Strömenlassen eines Behandlungsfluids in die Kammer und
- Beenden des Strömens des Behandlungsfluids,
dadurch gekennzeichnet,
- daß nach dem Beenden des Strömens des Behandlungsfluids eine laminare Strömung eines nicht behandelnden Spülfluids aufrechterhalten wird und
- daß das Substrat aus der Kammer entfernt wird, ohne das Strömen des Spülfluids zu unterbrechen.

2. Verfahren nach Anspruch 1, dadurch gekennzeichnet, daß der Schritt des Aufrechterhaltens des Strömens des Spülfluids den Beginn des Strömens des Spülfluids bei Beendigung des Strömens des Behandlungsgases einschließt.

3. Verfahren nach Anspruch 2, dadurch gekennzeichnet, daß das Spülfluid ein Gas ist, das aus der Familie ausgewählt wird, die aus Inertgasen und Stickstoff besteht.

4. Verfahren nach Anspruch 3, welches weiterhin den Schritt aufweist, das Spülgas konstant aus der Kammer abzuziehen.

5. Verfahren nach Anspruch 3, dadurch gekennzeichnet, daß das Substrat ein Halbleiterwafer ist.

6. Verfahren zum Betreiben einer Substratbehandlungskammer, in welcher eine Vielzahl von Substraten nacheinander einem Strom eines Behandlungsfluids ausgesetzt wird,
dadurch gekennzeichnet, daß das Verfahren den Schritt aufweist, eine laminare Strömung eines nicht behandelnden Spülfluids durch die Kammer aufrechtzuerhalten, wenn kein Substrat dem Behandlungsfluid ausgesetzt wird.

7. Verfahren nach Anspruch 6, welches weiterhin den Schritt aufweist, das Substrat aus der Kammer zu entfernen, dadurch gekennzeichnet, daß das Strömen des Spülfluids aufrechterhalten wird, bevor, während und nachdem das Substrat entfernt wird/worden ist.

8. Verfahren nach Anspruch 7, welches weiterhin den Schritt aufweist, ein Substrat in die Kammer einzuführen, dadurch gekennzeichnet, daß das Strömen des Spülfluids aufrechterhalten wird, bevor, während und nachdem das Substrat entfernt wird/worden ist.

9. Verfahren nach Anspruch 6, dadurch gekennzeichnet, daß der Schritt des Aufrechterhaltens der laminaren Strömung des Reinigungsfluids den Beginn des Strömens des Reinigungsfluids bei Beendigung des Strömens des Behandlungsgases einschließt.

10. Verfahren nach Anspruch 9, dadurch gekennzeichnet, daß das Spülfluid ein Gas ist, das aus der Familie ausgewählt wird, die aus den Edelgasen und Stickstoff besteht.

11. Verfahren nach Anspruch 10, welches weiterhin den Schritt aufweist, das Spülgas konstant aus der Kammer abzuziehen.

12. Verfahren nach Anspruch 11, dadurch gekennzeichnet, daß das Substrat ein Halbleiterwafer ist.

13. Vorrichtung zum Durchführen von Behandlungsvorgängen an einem Wafer
- mit einer Behandlungskammer (11), die für die Aufnahme des Wafers (14) ausgebildet ist, und
- mit einer Vielzahl von Fluidzuführungen (24 bis 34), die in Verbindung mit der Kammer stehen,
dadurch gekennzeichnet,
- daß eine Steuereinrichtung (34c) so ausgebildet ist, daß sie eine laminare Strömung eines Spülfluids aus wenigstens einer der Fluidzuführungen (34) zu der Kammer immer dann bereitstellt, wenn die Vorrichtung keine Behandlungsvorgänge an dem Wafer ausführt.

14. Vorrichtung nach Anspruch 13, dadurch gekennzeichnet, daß die Steuereinrichtung (34c) so ausgebildet ist, daß die Strömung des Spülfluids nach Beendingung des Strömens des Behandlungsfluids aus wenigstens einer der Fluidzuführungen aufrechterhalten wird.

15. Vorrichtung nach Anspruch 14, welche weiterhin einen Waferüberführungsmechanismus aufweist, der so gebaut ist, daß er den Wafer in die Kammer überführt und aus ihr herausführt, dadurch gekennzeichnet, daß die Steuereinrichtung (34c) so ausgebildet ist, daß sie das Strömen des Spülfluids während der Waferüberführung aufrechterhält.

16. Vorrichtung nach Anspruch 13, dadurch gekennzeichnet, daß die Steuereinrichtung (34c) so ausgebildet ist, daß das Strömen des Reinigungsfluids bei Beendigung des Strömens des Behandlungsfluids beginnt.

17. Vorrichtung nach Anspruch 13, dadurch gekennzeichnet, daß die Vielzahl der Fluidzuführungen, die mit der Kammer verbunden sind, Zuführungen (24, 34) für Spülfluidgas einschließt, das aus der Gruppe ausgewählt wird, die aus Inertgasen und Stickstoff besteht.

18. Vorrichtung nach Anspruch 13, dadurch gekennzeichnet, daß die Steuereinrichtung (34) in der Lage ist, einen viskosen Strom von Spülfluid bereitzustellen.

19. Vorrichtung nach Anspruch 13, welcher weiterhin eine Pumpe (40) aufweist, die so ausgebildet ist, daß sie Spülfluid konstant aus der Kammer abzieht.

## Revendications

1. Procédé de traitement d'un substrat dans un réacteur de traitement de substrat définissant une chambre de traitement, comprenant les étapes dans lesquelles :
on introduit le substrat dans la chambre ;
on fait s'écouler un fluide de traitement dans la chambre ; et on arrête l'écoulement du fluide de traitement ;
caractérisé en ce qu'un écoulement laminaire d'un fluide de purge ne réalisant pas de traitement est maintenu après -l'arrêt de l'écoulement du fluide de traitement ; et
le substrat est enlevé de la chambre sans interruption de l'écoulement du fluide de purge.

2. Procédé selon la revendication 1,
caractérisé en ce que l'étape de maintien de l'écoulement du fluide de purge comprend le commencement de l'écoulement du fluide de purge à l'arrêt de l'écoulement du gaz de traitement.

3. Procédé selon la revendication 2,
caractérisé en ce que le fluide de purge est un gaz choisi dans la famille constituée des gaz inertes et de l'azote.

4. Procédé selon la revendication 3, comprenant en outre l'étape consistant à évacuer de façon constante le gaz de purge de la chambre.

5. Procédé selon la revendication 3,
caractérisé en ce que le substrat est une tranche de semiconducteur.

6. Procédé de mise en oeuvre d'une chambre de traitement de substrats dans laquelle plusieurs substrats sont exposés consécutivement à un écoulement de fluide de traitement,
caractérisé en ce que le procédé comprend l'étape de maintien d'un écoulement laminaire d'un fluide de purge ne réalisant pas de traitement à travers la chambre lorsqu'un substrat n'est pas en cours d'exposition à un fluide de traitement.

7. Procédé selon la revendication 6, comprerant en outre l'étape d'enlèvement d'un substrat de la chambre, caractérisé en ce que l'écoulement du fluide de purge est maintenu avant, pendant et après l'enlèvement du substrat.

8. Procédé selon la revendication 7, comprenant en outre l'étape d'introduction d'un substrat dans la chambre, caractérisé en ce que l'écoulement du fluide de purge est maintenu avant, pendant et après l'enlèvement du substrat.

9. Procédé selon la revendication 6,
caractérisé en ce que l'étape de maintien de l'écoulement laminaire du fluide de purge comprend le commencement de l'écoulement du fluide de purge à l'arrêt de l'écoulement du gaz de traitement.

10. Procédé selon la revendication 9,
caractérisé en ce que le fluide de purge est un gaz choisi dans la famille constituée des gaz nobles et de l'azote.

11. Procédé selon la revendication 10, comprenant en outre l'étape consistant à évacuer de façon constante le gaz de purge de la chambre.

12. Procédé selon la revendication 11,
caractérisé en ce que le substrat est une tranche de semiconducteur.

13. Appareil pour effectuer les opérations de traitement sur une tranche, comportant :
une chambre de traitement (11) configurée de façon à renfermer la tranche (14) ;
et une pluralité d'alimentations en fluide (24 à 34) en communication avec la chambre ;
caractérisé en ce qu'un régulateur (34c) est configuré de façon à produire un écoulement laminaire d'un fluide de purge à partir d'au moins l'une des alimentations en fluide (34) vers la chambre lorsque l'appareil n'est pas en cours d'exécution d'opérations de traitement sur la tranche.

14. Appareil selon la revendication 13,
caractérisé en ce que le régulateur (34c) est configuré de façon à maintenir l'écoulement de fluide de purge après l'arrêt d'un écoulement d'un fluide de traitement depuis au moins l'une des alimentations en fluide.

15. Appareil selon la revendication 14, comportant en outre un mécanisme de transfert de tranche configuré pour transférer la tranche vers l'intérieur et l'extérieur de la chambre ; caractérisé en ce que le régulateur (34c) est configuré de façon à maintenir l'écoulement de fluide de purge pendant le transfert de la tranche.

16. Appareil selon la revendication 13, caractérisé en ce que le régulateur (34c) est configuré de façon à commencer l'écoulement de fluide de purge à l'arrêt de l'écoulement du fluide de traitement.

17. Appareil selon la revendication 13, caractérisé en ce que la pluralité d'alimentations en fluide raccordées à la chambre comprend des alimentations (24, 34) en fluide gazeux de purge choisies dans le groupe constitué de gaz inertes et d'azote.

18. Appareil selon la revendication 13, caractérisé en ce que le régulateur (34) peut produire un écoulement visqueux d'un fluide de purge.

19. Appareil selon la revendication 13, comportant en outre une pompe (40) configurée pour évacuer de façon constante le fluide de purge de la chambre.
